# NEUE EUROPÄISCHE PATENTSCHRIFT

(11) **EP 1 116 418 B2**
(45) Veröffentlichungstag und Bekanntmachung des Hinweises auf die Entscheidung über den Einspruch: **06.07.2011**
(45) Hinweis auf die Patenterteilung: 22.10.2003
(21) Anmeldenummer: 00956080.6
(22) Anmeldetag: 08.07.2000
(51) Int. Cl.: H05B 33/14, H01L 33/00, C09K 11/80, C09K 11/78

(54) **LEUCHSTOFF FÜR LICHTQUELLEN UND ZUGEHÖRIGE LICHTQUELLE**
LUMINOUS SUBSTANCE FOR A LIGHT SOURCE AND LIGHT SOURCE ASSOCIATED THEREWITH
SUBSTANCE FLUORESCENTE POUR SOURCES LUMINEUSES ET SOURCE LUMINEUSE CORRESPONDANTE

(30) Priorität: 23.07.1999 DE 19934126; 27.10.1999 DE 19951790; 30.12.1999 DE 19963791
(43) Veröffentlichungstag der Anmeldung: 18.07.2001
(60) Teilanmeldung: 03021392.0
(73) Patentinhaber: OSRAM Gesellschaft mit beschränkter Haftung, 81536 München (DE); OSRAM Opto Semiconductors GmbH, 93055 Regensburg (DE)
(72) Erfinder: KUMMER, Franz, D-80797 München (DE); ZWASCHKA, Franz, D-85737 Ismaning (DE); ELLENS, Andries, D-81735 München (DE); DEBRAY, Alexandra, D-92318 Neumarkt (DE); WAITL, Günther, D-93049 Regensburg (DE)
(74) Vertreter: Epping - Hermann - Fischer
(86) Internationale Anmeldenummer: PCT/DE2000/002241
(87) Internationale Veröffentlichungsnummer: WO 2001/008452

(56) Entgegenhaltungen:
- EP-A- 0 142 931
- GB-A- 2 000 173
- DATABASE WPI Section Ch, Week 200046 Derwent Publications Ltd., London, GB; Class L03, AN 2000-506318 XP002150848 & CN 1 254 747 A (CHANGCHUN PHYSICS INST CHINESE ACAD SCI), 31. Mai 2000 (2000-05-31)

## Beschreibung

Die Erfindung betrifft die Verwendung eines Leuchtstoffs mit einer Granatstruktur A₃B₅O₁₂ für die Anregung durch eine blau emittierende Strahlungsquelle gemäß dem Oberbegriff des Anspruchs 1 und des weiteren eine zugehörige Lichtquelle. Es handelt sich dabei insbesondere um einen gelb emittierenden Granat-Leuchtstoff für die Anregung durch eine Lichtquelle mit kurzen Wellenlängen im sichtbaren blauen Spektralbereich, wodurch weißes Licht erzeugt wird. Als Lichtquelle eignet sich eine LED (light emitting diode).

### Stand der Technik

Aus der WO 98/05078 ist bereits eine LED mit einem Granatleuchtstoff bekannt. Als Leuchtstoff wird dort ein Granat der Struktur A₃B₅O₁₂ eingesetzt, dessen Wirtsgitter als erste Komponente A aus mindestens einer der Seltenen Erdmetalle Y, Lu, Sc, La, Gd oder Sm besteht. Weiter wird für die zweite Komponente B eines der Elemente Al, Ga oder In verwendet. Als Dotierstoff wird ausschließlich Ce eingesetzt.

Aus der WO 97/50132 ist ein sehr ähnlicher Leuchtstoff bekannt. Als Dotierstoff wird dort entweder Ce oder Tb eingesetzt. Während Ce im gelben Spektralbereich emittiert, liegt die Emission des Tb im grünen Spektralbereich. In beiden Fällen wird das Prinzip der Komplementärfarbe (blau emittierende Lichtquelle und gelb emittierender Leuchtstoff) zur Erzielung einer weißen Lichtfarbe verwendet.

Schließlich ist in EP-A 124 175 eine Leuchtstofflampe beschrieben, die neben einer Quecksilberfüllung mehrere Leuchtstoffe enthält. Diese werden durch die UV-Strahlung (254 nm) oder auch durch die kurzwellige Strahlung bei 460 nm angeregt. Drei Leuchtstoffe sind so gewählt, dass sie sich zu weiß addieren (Farbmischung).

### Darstellung der Erfindung

Es ist eine Aufgabe der vorliegenden Erfindung, ein neues Anwendungsgebiet für einen Leuchtstoff mit einer Granatstruktur A3B5O12 anzugeben sowie eine entsprechende Lichtquelle bereitzustellen.

Diese Aufgabe wird durch die kennzeichnenden Merkmale des Anspruchs 1 gelöst. Besonders vorteilhafte Ausgestaltungen finden sich in den abhängigen Ansprüchen.

Erfindungsgemäß wird ein Leuchtstoff, der eine Granatstruktur A₃B₅O₁₂ besitzt und der mit Ce dotiert ist, für Lichtquellen, deren Emission im kurzwelligen optischen Spektralbereich-im Bereich 420 bis 490 nm liegt, verwendet, wobei die zweite Komponente B mindestens eines der Elemente Al und Ga repräsentiert, wobei die erste Komponente A Terbium in einer Mindestmenge von 1 mol-% der Komponente A enthält. Überraschenderweise hat sich herausgestellt, dass sich Terbium (Tb) unter besonderen Umständen, nämlich bei blauer Anregung im Bereich 420 bis 490 nm, als Bestandteil des Wirtsgitters (erste Komponente A des Granats) für einen gelb emittierenden Leuchtstoff eignet, dessen Aktivator Cer ist. Bisher wurde Tb in diesem Zusammenhang lediglich als Aktivator oder Koaktivator neben Cer für die Emission im Grünen in Betracht gezogen, wenn die Anregung durch Kathodenstrahlen (Elektronen) wie bei GB-A 2 000 173 oder kurzwellige UV-Photonen erfolgt (GB-A 1 600 492 und EP-A 208 713 sowie EP-A 142 931).

Dabei kann Terbium als Hauptbestandteil der ersten Komponente A des Granats in Alleinstellung oder zusammen mit mindestens einer der Seltenerdmetalle Y, Gd, La u/o Lu verwendet werden.

Als zweite Komponente wird mindestens eines der Elemente Al oder Ga verwendet. Die zweite Komponente B kann zusätzlich In enthalten. Der Aktivator ist Cer.

In einer besonders bevorzugten Ausführungsform wird ein Granat der Struktur
(Tb_{1-x-y}SEₓCe_{y})₃(Al, Ga)₅O₁₂ verwendet, wobei
SE = Y, Gd, La und/oder Lu;
0≤x≤0,5-y; 0<y<0,1 gilt.

Der Leuchtstoff absorbiert im Bereich 420 bis 490 nm und kann so durch die Strahlung einer blauen Lichtquelle, die insbesondere die Strahlungsquelle für eine Lampe oder LED ist, angeregt werden. Gute Ergebnisse wurden mit einer blauen LED erzielt, deren Emissionsmaximum bei 430 bis 470 nm lag. Das Maximum der Emission des Tb-Granat:Ce-Leuchtstoffs liegt bei etwa 550 nm.

Dieser Leuchtstoff eignet sich besonders für die Verwendung in einer weißen LED, beruhend auf der Kombination einer blauen LED mit dem Tb-Granat-haltigen Leuchtstoff, der durch Absorption eines Teils der Emission der blauen LED angeregt wird und dessen Emission die übrig bleibende Strahlung der LED zu weißem Licht ergänzt.

Als blaue LED eignet sich insbesondere eine Ga(In)N-LED, aber auch jeder andere Weg zur Erzeugung einer blauen LED mit einer Emission im Bereich 420 bis 490 nm. Insbesondere wird als hauptsächlicher Emissionsbereich 430 bis 470 nm empfohlen, da dann die Effizienz am höchsten ist.

Durch die Wahl von Art und Menge an Seltenerdmetallen ist eine Feineinstellung der Lage der Absorptions- und der Emissionsbande möglich, ähnlich wie dies für andere Leuchtstoffe des Typs YAG:Ce aus der Literatur bekannt ist. In Verbindung mit Leuchtdioden eignet sich vor allem ein Bereich für x, der zwischen 0,25 ≤ x ≤ 0,5-y liegt.
Der besonders bevorzugte Bereich von y liegt bei 0,02 < y < 0,06. Der Leuchtstoff eignet sich auch zur Kombination mit anderen Leuchtstoffen.

Gute Eignung als Leuchtstoff zeigt ein Granat der Struktur

(TbₓSE_{1-x-y}Ce_{y})₃(Al,Ga)₅O₁₂,

wobei SE = Y, Gd, La und/oder Lu;
0,01 ≤ x ≤ 0,02, insbesondere x = 0,01;
0 < y < 0,1 gilt. Häufig liegt y im Bereich 0,01 bis 0,05.

Generell dienen kleinere Mengen an Tb im Wirtsgitter vor allem dazu, die Eigenschaften bekannter Cer-aktivierter Leuchtstoffe zu verbessern, während die Zugabe größerer Mengen an Tb gezielt vor allem dafür eingesetzt werden kann, die Wellenlänge der Emission bekannter Cer-aktivierter Leuchtstoffe zu verschieben. Daher eignet sich ein hoher Anteil Tb besonders gut für weiße LED mit niedriger Farbtemperatur unter 5000 K.

### Figuren

Im folgenden soll die Erfindung anhand mehrerer Ausführungsbeispiele näher erläutert werden. Es zeigen:
- Figur 1: ein Emissionsspektrum eines ersten Tb-Granat-Leuchtstoffs;
- Figur 2: das Remissionsspektrum dieses Tb-Granat-Leuchtstoffs;
- Figur 3: Emissionsspektren weiterer Tb-Granat-Leuchtstoffe;
- Figur 4: Remissionsspektren der Tb-Granat-Leuchtstoffe aus Figur 3;
- Figur 5: Emissionsspektren weiterer Tb-Granat-Leuchtstoffe;
- Figur 6: Remissionsspektren der Tb-Granat-Leuchtstoffe aus Figur 5;
- Figur 7: ein Emissionsspektrum einer weißen LED mit Tb-Granat-Leuchtstoff.

### Beschreibung mehrerer Ausführungsbeispiele

### Ausführungsbeispiel Nr. 1:

### Die Komponenten

| | |
|---|---|
| 9,82 g | Yttriumoxid Y₂O₃ |
| 2,07 g | Ceroxid CeO₂ |
| 37,57 g | Terbiumoxid Tb₄O₇ |
| 26,41 g | Aluminiumoxid Al₂O₃ |
| 0,15 g | Bariumfluorid BaF₂ |
| 0,077 g | Borsäure H₃BO₃ |

werden vermischt und in einer 250-ml-Polyethylen-Weithalsflasche mit 150 g Aluminiumoxidkugeln von 10 mm Durchmesser zwei Stunden lang zusammen vermahlen.

Dabei dienen Bariumfluorid und Borsäure als Flußmittel. Die Mischung wird in einem bedeckten Korundtiegel für drei Std. bei 1550 °C in Formiergas (Stickstoff mit 2,3 Vol-% Wasserstoff) geglüht. Das Glühgut wird in einer automatischen Mörsermühle gemahlen und durch ein Sieb von 53 µm Maschenweite gesiebt. Anschließend erfolgt eine zweite Glühung für drei Std. bei 1500 °C in Formiergas (Stickstoff mit 0,5 Vol-% Wasserstoff). Danach wird wie nach der ersten Glühung gemahlen und gesiebt. Der erhaltene Leuchtstoff entspricht der Zusammensetzung (Y_{0,29}Tb_{0,67}Ce_{0,04})₃Al₅O₁₂. Er weist eine kräftig gelbe Körperfarbe auf. Ein Emissionsspektrum dieses-Leuchtstoffs bei Anregung mit 430 nm und ein Remissionsspektrum des Leuchtstoffs zwischen 300 und 800 nm sind in Figur 1 und 2 wiedergegeben.

### Ausführungsbeispiel Nr. 2:

### Die Komponenten

| | |
|---|---|
| 43,07 g | Terbiumoxid Tb₄O₇ |
| 1,65 g | Ceroxid CeO₂ |
| 21,13 g | Aluminiumoxid Al₂O₃ |
| 0,12 g | Bariumfluorid BaF₂ |
| 0,062 g | Borsäure H₃BO₃ |

werden wie unter Beispiel Nr. 1 beschrieben innig gemischt. Zwei Glühungen und die weitere Aufarbeitung der Glühprodukte erfolgen wie unter Beispiel 1 beschrieben. Der erhaltene Leuchtstoff entspricht der gesamten Zusammensetzung (Tb_{0.96}Ce_{0.04})₃Al₅O₁₂ oder in der das Wirtsgitter verdeutlichenden Darstellung Tb₃Al₅O₂₁:Ce. Er weist eine kräftig gelbe Körperfarbe auf. Das Röntgenbeugungsdiagramm zeigt, dass eine kubische Granatphase vorliegt. Das Emissionsspektrum und Remissionsspektrum dieses Leuchtstoffs ist in Figur 3 bzw. 4 gezeigt.

### Ausführungsbeispiel Nr. 3:

### Die Komponenten

| | |
|---|---|
| 32,18 g | Yttriumoxid Y₂O₃ |
| 0,56 g | Terbiumoxid Tb₄O₇ |
| 2,07 g | Ceroxid CeO₂ |
| 26,41 g | Aluminiumoxid Al₂O₃ |
| 0,077 g | Borsäure H₃BO₃ |

werden wie unter Beispiel Nr. 1 beschrieben innig gemischt. Zwei Glühungen und Aufarbeitung der Glühprodukte erfolgen wie unter Beispiel Nr. 1 beschrieben. Der erhaltene Leuchtstoff entspricht der Zusammensetzung (Y_{0.95}Tb_{0.01}Ce_{0.04})₃Al₅O₁₂. Er weist eine kräftig gelbe Körperfarbe auf. Das Emissionsspektrum und Remissionsspektrum dieses Leuchtstoffs ist in Figur 3 bzw. 4 gezeigt.

### Ausführunosbeispiel Nr. 4:

### Die Komponenten

| | |
|---|---|
| 26,76 g | Yttriumoxid Y₂O₃ |
| 9,53 g | Terbiumoxid Tb₄O₇ |
| 2,07 g | Ceroxid CeO₂ |
| 26,41 g | Aluminiumoxid Al₂O₃ |
| 0,149 g | Bariumfluorid BaF₂ |
| 0,077 g | Borsäure H₃BO₃ |

werden wie unter Beispiel Nr. 1 beschrieben innig gemischt. Zwei Glühungen und Aufarbeitung der Glühprodukte erfolgen wie unter Beispiel Nr. 1 beschrieben. Der erhaltene Leuchtstoff entspricht der Zusammensetzung (Y_{0.79}Tb_{0.17}Ce_{0.04})₃Al₅O₁₂. Er weist eine kräftig gelbe Körperfarbe auf. Das Emissionsspektrum und Remissionsspektrum dieses Leuchtstoffs ist in Figur 3 bzw. 4 gezeigt.

### Ausführungsbeispiel Nr. 5:

### Die Komponenten

| | |
|---|---|
| 30,82 g | Yttriumoxid Y₂O₃ |
| 0.56 g | Terbiumoxid Tb₄O₇ |
| 4,13 g | Ceroxid CeO₂ |
| 26,41 g | Aluminiumoxid Al₂O₃ |
| 0,149 g | Bariumfluorid BaF₂ |
| 0,077 g | Borsäure H₃BO₃ |

werden wie unter Beispiel Nr. 1 beschrieben innig gemischt. Zwei Glühungen und Aufarbeitung der Glühprodukte erfolgen wie unter Beispiel Nr. 1 beschrieben. Der erhaltene Leuchtstoff entspricht der Zusammensetzung (Y_{0.91}Tb_{0.01}Ce_{0.08})₃Al₅O₁₂. Er weist eine kräftig gelbe Körperfarbe auf.

### Ausführungsbeispiel Nr. 6:

### Die Komponenten

| | |
|---|---|
| 43,07 g | Terbiumoxid Tb₄O₇ |
| 1,65 g | Ceroxid CeO₂ |
| 21,13 g | Aluminiumoxid Al₂O₃ |
| 0,062 g | Borsäure H₃BO₃ |

werden wie unter Beispiel Nr. 1 beschrieben innig gemischt. Zwei Glühungen und Aufarbeitung der Glühprodukte erfolgen wie unter Beispiel 1 beschrieben, jedoch ist die Glühtemperatur bei den beiden Glühungen jeweils 50 °C niedriger. Der erhaltene Leuchtstoff entspricht der Zusammensetzung (Tb_{0.96}Ce_{0.04})₃Al₅O₁₂. Er weist eine kräftig gelbe Körperfarbe auf. Das Emissionsspektrum und Remissionsspektrum dieses Leuchtstoffs ist in Figur 5 bzw. 6 gezeigt.

### Ausführungsbeispiel Nr. 7:

### Die Komponenten

| | |
|---|---|
| 43,07 g | Terbiumoxid Tb₄O₇ |
| 1,65 g | Ceroxid CeO₂ |
| 17,05 g | Aluminiumoxid Al₂O₃ |
| 7,50 g | Galliumoxid Ga₂O₃ |
| 0,062 g | Borsäure H₃BO₃ |

werden wie unter Beispiel Nr. 1 beschrieben innig gemischt. Zwei Glühungen und Aufarbeitung der Glühprodukte erfolgen wie unter Beispiel 1 beschrieben, jedoch ist die Glühtemperatur bei beiden Glühungen jeweils 50 °C niedriger. Der erhaltene Leuchtstoff entspricht der Zusammensetzung (Tb_{0.96}Ce_{0.04})₃Al₄GaO₁₂. Er weist eine kräftig gelbe Körperfarbe auf. Das Emissionsspektrum und Remissionsspektrum dieses Leuchtstoffs ist in Figur 5 bzw. 6 gezeigt.

### Ausführungsbeispiel Nr. 8:

### Die Komponenten

| | |
|---|---|
| 43,07 g | Terbiumoxid Tb₄O₇ |
| 1,65 g | Ceroxid CeO₂ |
| 12,97 g | Aluminiumoxid Al₂O₃ |
| 15,00 g | Galliumoxid Ga₂O₃ |
| 0,062 g | Borsäure H₃BO₃ |

werden wie unter Beispiel Nr. 1 beschrieben innig gemischt. Zwei Glühungen und Aufarbeitung der Glühprodukte erfolgen wie unter Beispiel 1 beschrieben, jedoch ist die Glühtemperatur bei beiden Glühungen jeweils 50 °C niedriger. Der erhaltene Leuchtstoff entspricht der Zusammensetzung (Tb_{0.96}Ce_{0.04})Al₃Ga₂O₁₂. Er weist eine gelbe Körperfarbe auf. Das Emissionsspektrum und Remissionsspektrum dieses Leuchtstoffs ist in Figur 5 bzw. 6 gezeigt.

### Ausführungsbeispiel Nr. 9:

### Die Komponenten

| | |
|---|---|
| 4,88 kg | Yttriumoxid Y₂O₃ |
| 7,05 kg | Gadoliniumoxid Gd₂O₃ |
| 161,6 g | Terbiumoxid Tb₄O₇ |
| 595 g | Ceroxid CeO₂ |
| 7,34 kg | Aluminiumoxid Al₂O₃ |
| 5,50 g | Borsäure H₃BO₃ |

werden in einem 60 l Polyethylenfass 24 Stunden gemischt. Die Mischung wird in Glühtiegel aus Aluminiumoxid von ca. 1 l Fassungsvermögen eingefüllt und in einem Durchschubofen 6 Stunden bei 1550 °C in Formiergas geglüht. Das geglühte Material wird in einer automatischen Mörsermühle gemahlen und anschließend fein gesiebt. Der erhaltene Leuchtstoff hat die Zusammensetzung (Y_{0.50}Gd_{0.45}Tb_{0.01}Ce_{0.04})₃Al₅O₁₂. Er weist eine kräftig gelbe Körperfarbe auf. Das Emissionsspektrum und Remissionsspektrum dieses Leuchtstoffs ist in Figur 3 bzw. 4 gezeigt.

### Ausführungsbeispiel Nr. 10 (LED):

Beim Einsatz dieser Leuchtstoffe in einer weißen LED zusammen mit GalnN wird ein Aufbau ähnlich wie in WO 97/50132 beschrieben verwendet. Beispielweise werden gleiche Teile von Leuchtstoff nach Beispiel 1 und von Leuchtstoff nach Beispiel 4 in Epoxidharz dispergiert und mit dieser Harzmischung eine LED mit einem Emissionsmaximum von etwa 450 nm (blau) umhüllt. Das Emissionsspektrum einer so erhaltenen weißen LED ist in Figur 7 dargestellt. Die Mischung der blauen LED-Strahlung mit der gelben Leuchtstoff-Emission ergibt in diesem Fall einen Farbort von x = 0,359 / y = 0,350, entsprechend weißem Licht der Farbtemperatur 4500 K.

Die oben beschriebenen Leuchtstoffe weisen im allgemeinen gelbe Körperfarbe auf. Sie emittieren im gelben Spektralbereich. Bei Zugabe oder alleiniger Verwendung von Ga statt Al verschiebt sich die Emission mehr in Richtung grün, so dass sich insbesondere auch höhere Farbtemperaturen realisieren lassen. Insbesondere können Ga-haltige (oder Ga,Al-haltige) Tb-Granate und rein Al-haltige Tb-Granate gemischt verwendet werden um eine Anpassung an gewünschte Farbörter vornehmen zu können.

## Patentansprüche

1. Verwendung eines Leuchtstoffs mit einer Granatstruktur A₃B₅O₁₂ für die Anregung durch eine blau emittierende Strahlungsquelle, deren Emission im kurzwelligen optischen Spektralbereich von 420 bis 490 nm liegt, wobei der Leuchtstoff mit Ce aktiviert ist entsprechend der Darstellung A₃B₅O₁₂:Ce, wobei die zweite Komponente B mindestens eines der Elemente Al und Ga repräsentiert, wobei die erste Komponente A Terbium enthält und zwar in einer Mindestmenge von 1 mol-%, wobei
- ein Granat der Struktur (TbₓSE_{1-x-y}Ce_{y})₃(Al, Ga)₅O₁₂ verwendet wird, bei dem SE = Y, Gd, La und/oder Lu und 0,01≤x<1,0, 0<y<0,1,
und
- die Strahlungsquelle eine Leuchtdiode ist.

2. Verwendung eines Leuchtstoffs nach Anspruch 1, **dadurch gekennzeichnet, dass** der Leuchtstoff durch eine Strahlung im Bereich 430 bis 470 nm, anregbar ist.

3. Verwendung eines Leuchtstoffs nach Anspruch 1, **dadurch gekennzeichnet, dass** ein Granat der Struktur (Tb_{1-x-y}SEₓCe_{y})₃(Al,Ga)₅O₁₂ verwendet, wobei
SE = Y, Gd, La und/oder Lu;
0≤ₓ≤0,5-y;
0<y<0,1 gilt.

4. Lichtquelle, die primär Strahlung im kurzwelligen Bereich des optischen Spektralbereichs zwischen 420 und 490 nm emittiert, wobei diese Strahlung teilweise oder vollständig mittels eines Leuchtstoffs nach einem der vorhergehenden Ansprüche 1 bis 3 in längerwellige Strahlung konvertiert wird, und
als primäre Strahlungsquelle eine blau emittierende Leuchtdiode verwendet wird.

5. Lichtquelle nach Anspruch 4, **dadurch gekennzeichnet, dass** die primär emittierte Strahlung im Wellenlängenbereich 430 bis 470 nm liegt.

6. Lichtquelle nach Anspruch 4, **dadurch gekennzeichnet, dass** als primäre Strahlungsquelle eine blau emittierende Leuchtdiode auf Basis von Ga(In)N verwendet wird.

## Claims

1. Use of a phosphor having a garnet structure A₃B₅O₁₂ for excitation by a blue-emitting radiation source, the emission from which lies in the short-wave optical spectral region from 420 to 490 nm, the phosphor being activated with Ce as represented by the description A₃B₅O₁₂:Ce, the second component B representing at least one of the elements Al and Ga and the first component A containing terbium, specifically in an amount of at least 1 mol%,
wherein
- a garnet of the structure (TbₓRE_{1-x-y}Ce_{y})₃(Al,Ga)₅O₁₂ is used, in which
RE = Y, Gd, La and/or Lu and 0.01 ≤ x < 1.0,
0 < y < 0.1,
and
- the radiation source is a light-emitting diode.

2. Use of a phosphor according to Claim 1, **characterized in that** the phosphor can be excited by radiation in the range from 430 to 470 nm.

3. Use of a phosphor according to Claim 1, **characterized in that** a garnet of the structure (Tb_{1-x-y}REₓCe_{y})₃(Al,Ga)₅O₁₂, where
RE = Y, Gd, La and/or Lu;
0 ≤ x ≤ 0.5-y;
0 < y < 0.1
is used.

4. Light source which primarily emits radiation in the short-wave region of the optical spectral region between 420 and 490 nm, this radiation being partially or completely converted into longer-wave radiation by means of a phosphor according to one of the preceding Claims 1 to 3, and
the primary radiation source used being a blue-emitting light-emitting diode.

5. Light source according to Claim 4, **characterized in that** the primary radiation emitted is in the wavelength range from 430 to 470 nm.

6. Light source according to Claim 4, **characterized in that** the primary radiation source used is a blue-emitting light-emitting diode based on Ga(In)N.

## Revendications

1. Utilisation d'une substance luminescente à structure de grenat A₃B₅O₁₂ pour l'exciter par une source de rayonnement émettant dans le bleu et dont l'émission est située dans la plage spectrale visible des courtes longueurs d'onde de 420 à 490 nm,
la substance luminescente étant activée au Ce selon la représentation A₃B₅O₁₂:Ce, le deuxième composant B représentant au moins l'un des éléments Al et Ga, le premier composant A contenant du terbium à une teneur minimale de 1 % en moles,
le grenat utilisé ayant la structure (TbₓSE_{1-x-y}Ce_{y})₃(Al, Ga)₅O₁₂ dans laquelle SE = Y, Gd, La et/ou Lu, 0,01 ≤ x < 1,0 et 0 < y < 0,1, et
la source de rayonnement étant une diode luminescente.

2. Utilisation d'une substance luminescente selon la revendication 1, **caractérisée en ce que** la substance luminescente peut être excitée par un rayonnement dans la plage de 430 à 470 nm.

3. Utilisation d'une substance luminescente selon la revendication 1, **caractérisé en ce que** le grenat utilisé a la structure (Tb_{1-x-y}SEₓCe_{y})₃(Al, Ga)₅O₁₂ dans laquelle SE = Y, Gd, La et/ou Lu,
0 ≤ x ≤ 0,5-y et
0 < y < 0,1.

4. Source lumineuse qui émet un rayonnement primaire dans la plage des courtes longueurs d'onde du spectre visible, entre 420 et 490 nm, ce rayonnement étant converti en partie ou en totalité en un rayonnement de plus grande longueur d'onde au moyen d'une substance luminescente selon l'une des revendications 1 à 3 qui précèdent, et utilisant comme source primaire de rayonnement une diode luminescente émettant dans le bleu.

5. Source de lumière selon la revendication 4, **caractérisée en ce que** le rayonnement primaire est émis dans la plage de longueur d'onde de 430 à 470 nm.

6. Source de lumière selon la revendication 4, **caractérisée en ce que** comme source de rayonnement primaire, elle utilise une diode luminescente émettant dans le bleu et à base de Ga(In)N.
